# EUROPEAN PATENT APPLICATION

(11) **EP 4 529 368 A1**
(43) Date of publication of application: **26.03.2025**
(21) Application number: 22942766.1
(22) Date of filing: 20.05.2022
(51) Int. Cl.: H05K 3/00, H05K 1/02, H05K 3/46

(54) **MANUFACTURING METHOD AND MANUFACTURING DEVICE**

(71) Applicant: Fuji Corporation, Chiryu-shi, Aichi 472-8686 (JP)
(72) Inventor: TOMINAGA, Ryojiro, Chiryu-shi, Aichi 472-8686 (JP)
(74) Representative: Grünecker Patent- und Rechtsanwälte PartG mbB
(86) International application number: PCT/JP2022/021020
(87) International publication number: WO 2023/223562

(57) **Abstract**

In a manufacturing method, a resin layer forming step and a wire forming step are repeatedly executed to form multiple terminal-attached resin layers each including a terminal portion connected to an electronic component on a surface of a resin layer, a mark pedestal is formed by building up the resin layer in a mark formation area in the stage up to a resin layer forming step of forming a resin layer of the terminal-attached resin layer out of multiple resin layer forming steps, a reference mark is formed by discharging a first metallic fluid onto the mark pedestal in the wire forming step of forming the wire of the terminal-attached resin layer, and when the multiple terminal-attached resin layers are formed at positions of different heights, the mark pedestals corresponding to the heights of the multiple terminal-attached resin layers are formed in the mark formation area, and the reference marks are formed on multiple mark pedestals, respectively.

## Description

### Technical Field

The present disclosure relates to a technology for manufacturing a board using a three-dimensional additive manufacturing.

### Background Art

Conventionally, various methods have been proposed as a manufacturing method of a board. For example, Patent Literature 1 below describes that a board is additively manufactured using a 3D printer. In the manufacturing method according to Patent Literature 1, multiple resin layers in which a wire and a reference mark are formed are formed by a 3D printer, and the multiple formed resin layers are built up layer by layer to manufacture a board. When the layers are built up layer by layer, the resin layers of the layers are positioned and built up with reference to center coordinates of the reference marks of a lower layer.

### Prior Art Literature

### Patent Literature

Patent Literature 1:WO 2020/250381

### Summary of the Invention

### Technical Problem

When an electronic component is mounted on a board after the above-described board is formed by the three-dimensional additive manufacturing, positional adjustment between an electrode of the electronic component and a terminal portion of a wire formed on a surface of the board is required. Further, multiple electronic components may be mounted on wires formed at different heights. In such a case, it is desirable that the position of each of the multiple electronic components connected to the terminal portions of the wires having different heights can be adjusted with high accuracy.

The present disclosure has been made in view of such circumstances, and an object of the present disclosure is to provide a manufacturing method and a manufacturing device that can manufacture a board that can improve the accuracy of positional adjustment between an electronic component and a terminal portion even in a case where heights at which multiple electronic components are mounted are different when forming a board by using a three-dimensional additive manufacturing.

### Solution to Problem

**In** order to solve the above problems, the present disclosure discloses a manufacturing method including: a resin layer forming step of forming a resin layer by discharging a curable resin to a formation area in a stage; and a wire forming step of forming a wire by discharging a first metallic fluid containing metal fine particles on the resin layer, in which the resin layer forming step and the wire forming step are repeatedly executed to form multiple terminal-attached resin layers each including a terminal portion on a surface of the resin layer, the terminal portion being a part of the wire and connected to an electronic component to be mounted on the wire, a mark pedestal is formed by building up the resin layer in a mark formation area up to a resin layer forming step of forming a resin layer of the terminal-attached resin layer out of multiple resin layer forming steps, the mark formation area being an area different from the formation area in the stage, a reference mark is formed by discharging the first metallic fluid onto the mark pedestal in the wire forming step of forming the wire of the terminal-attached resin layer, and when the multiple terminal-attached resin layers are formed at positions of different heights, the mark pedestals corresponding to the heights of the multiple terminal-attached resin layers are formed in the mark formation area, and the reference marks are formed on multiple mark pedestals, respectively.

In addition, the content of the present disclosure is not limited to implementation as the manufacturing method, and the present disclosure is also extremely effective to be implemented as a manufacturing device including a stage, a discharging device, and a control device.

### Advantageous Effects of Invention

In the present disclosure, mark pedestals corresponding to the heights of the multiple terminal-attached insulating layers are formed, and a reference mark is formed on each of the multiple mark pedestals. When the electronic component is mounted on each of the terminal-attached insulating layers, the position can be adjusted using the reference mark on the mark pedestal corresponding to the height of each of the terminal-attached insulating layers. Accordingly, even when the heights at which the multiple electronic components are mounted are different from each other, it is possible to manufacture the board that can improve the accuracy of the positional adjustment between the electronic component and the terminal portion.

### Brief Description of Drawings

Fig. 1 is a view illustrating a board manufacturing device according to the present embodiment.
Fig. 2 is a block diagram of the board manufacturing device.
Fig. 3 is a plan view illustrating a region in a pallet.
Fig. 4 is a cross-sectional view illustrating a state in which a first-layer resin layer is formed.
Fig. 5 is a cross-sectional view illustrating a state in which a wire is formed on the first-layer resin layer.
Fig. 6 is a cross-sectional view illustrating a state in which a second-layer resin layer is formed.
Fig. 7 is a cross-sectional view of a board.
Fig. 8 is a plan view of a reference mark and a mark pedestal.
Fig. 9 is a side view of the reference mark and the mark pedestal.
Fig. 10 is a cross-sectional view of the board after an electronic component is mounted.
Fig. 11 is a cross-sectional view of a board after an electronic component of another example is mounted.
Fig. 12 is a plan view illustrating a region in a pallet of another example.

### Description of Embodiments

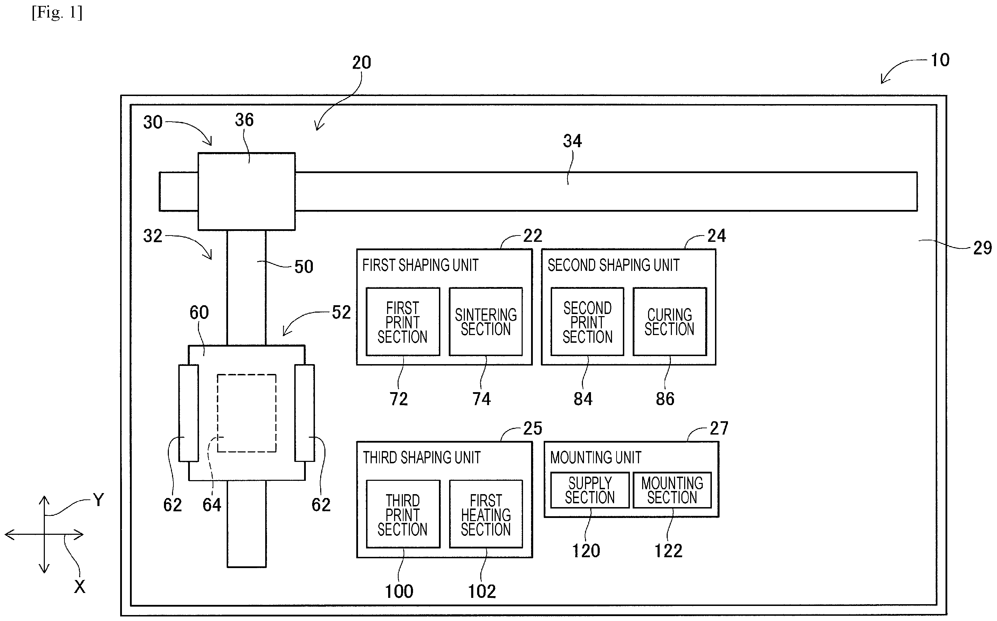

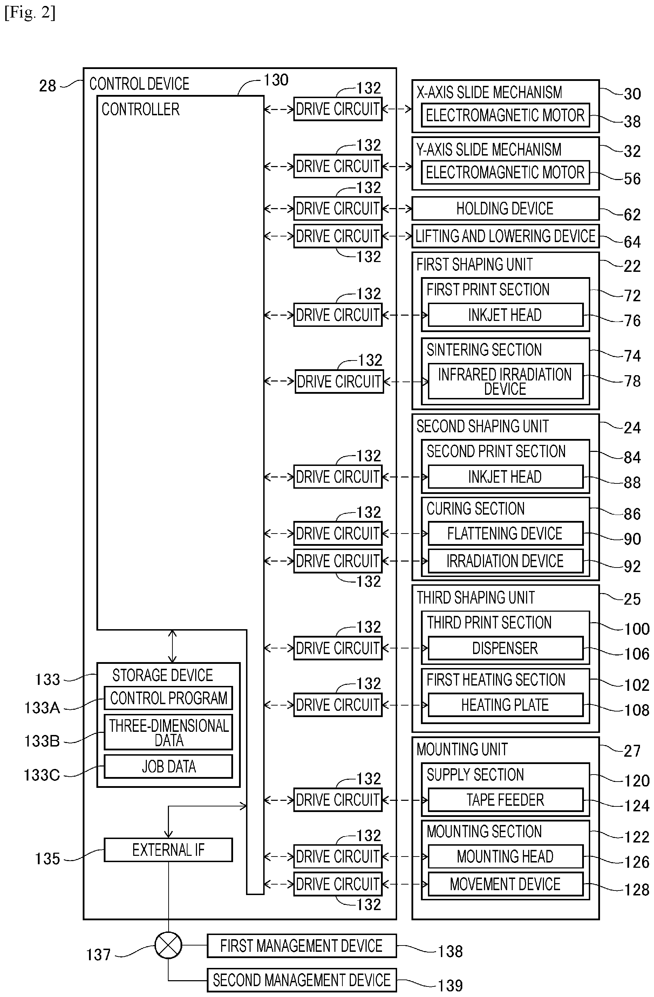

Hereinafter, a board manufacturing device as an embodiment of a manufacturing device of the present disclosure will be described with reference to the drawings. Fig. 1 illustrates board manufacturing device 10 according to the present embodiment. As illustrated in Fig. 1, board manufacturing device 10 includes conveyance device 20, first shaping unit 22, second shaping unit 24, third shaping unit 25, mounting unit 27, and control device 28 (see Fig. 2). Board manufacturing device 10 is a device in which a board is additively manufactured using an inkjet method, and an electronic component is mounted on the shaped board by using three-dimensional additive manufacturing. The three-dimensional additive manufacturing used by board manufacturing device 10 is not limited to the inkjet method, and other additive manufacturing such as fused deposition modeling and selective laser sintering may also be used.

Conveyance device 20, first shaping unit 22, second shaping unit 24, third shaping unit 25, and mounting unit 27 are arranged on base 29 of board manufacturing device 10. Base 29 generally has a rectangular shape. In the following description, as illustrated in Fig. 1, a longitudinal direction of base 29 will be referred to as an X-axis direction, a transverse direction of base 29 will be referred to as a Y-axis direction, and a direction orthogonal to both the X-axis direction and the Y-axis direction will be referred to as a Z-axis direction.

Conveyance device 20 includes X-axis slide mechanism 30 and Y-axis slide mechanism 32. X-axis slide mechanism 30 includes X-axis slide rail 34 and X-axis slider 36. X-axis slide rail 34 is provided on base 29 and is arranged along the X-axis direction. X-axis slider 36 is held by X-axis slide rail 34 to be slidable in the X-axis direction. X-axis slide mechanism 30 further includes electromagnetic motor 38 (refer to Fig. 2), and moves X-axis slider 36 to any position in the X-axis direction by driving electromagnetic motor 38.

In addition, Y-axis slide mechanism 32 includes Y-axis slide rail 50 and stage 52. Y-axis slide rail 50 is provided on base 29 and is arranged along the Y-axis direction. One end portion (upper end in Fig. 1) of Y-axis slide rail 50 is coupled to X-axis slider 36. Thus, Y-axis slide mechanism 32 is movable in the X-axis direction together with X-axis slider 36. Stage 52 is held by Y-axis slide rail 50 to be slidable in the Y-axis direction. Y-axis slide mechanism 32 has electromagnetic motor 56 (refer to Fig. 2), and moves stage 52 to any position in the Y-axis direction by driving electromagnetic motor 56. Thus, stage 52 can be moved to any position on base 29 in the X-axis direction and the Y-axis direction by the driving of X-axis slide mechanism 30 and Y-axis slide mechanism 32.

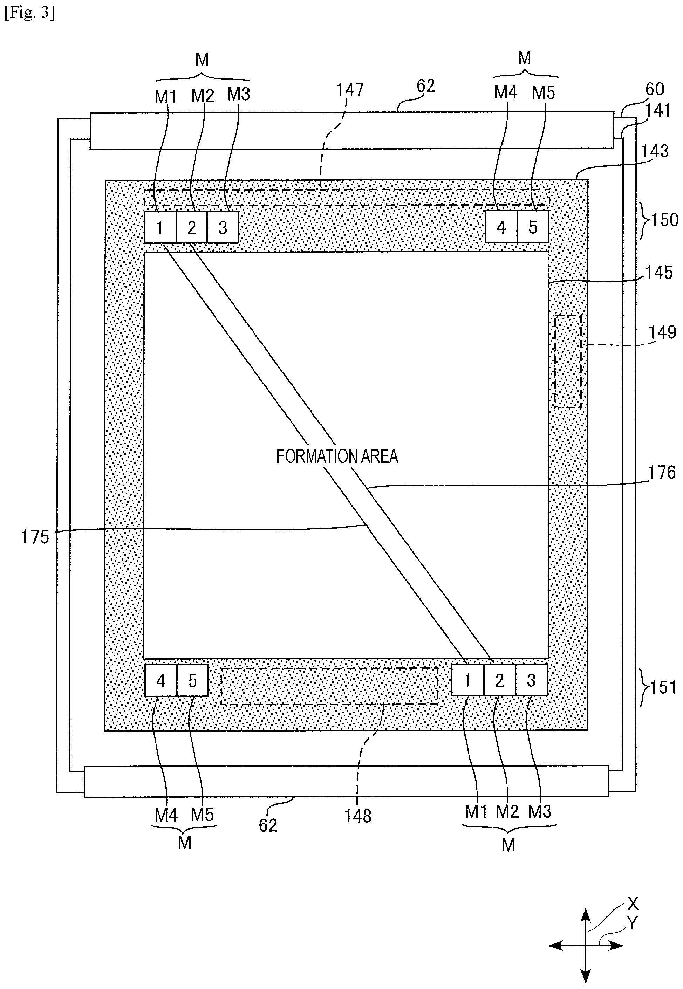

Stage 52 includes base table 60, holding device 62, and lifting and lowering device 64. Base table 60 is formed in a flat plate shape, and a board is placed on an upper surface thereof. Holding device 62 is provided on both side portions of base table 60 in the X-axis direction. For example, pallet 141 (see Fig. 3) for shaping a board is arranged on base table 60. Pallet 141 is, for example, a thin plate-shaped member made of metal. For example, release film 143 (see Fig. 3) is attached onto pallet 141, and a board is manufactured on release film 143. Release film 143 is, for example, a film-shaped member whose adhesive strength is reduced by heat equal to or higher than a predetermined temperature, and is used to separate the board from pallet 141 after the board is manufactured. Pallet 141 is placed on base table 60 and is fixedly held with respect to base table 60 by sandwiching both edge portions in the X-axis direction via holding device 62. Lifting and lowering device 64 is provided below base table 60 to lift and lower base table 60 in the Z-axis direction.

First shaping unit 22 is a unit for shaping a wire on base table 60 of stage 52, and includes first print section 72 and sintering section 74. First print section 72 includes inkjet head 76 (refer to Fig. 2), and inkjet head 76 linearly discharges metal ink. The metal ink is ink obtained by dispersing nanometer-sized metal such as silver fine particles in an organic solvent. Surfaces of the metal fine particles are coated with, for example, a dispersing agent to prevent aggregation in the organic solvent. Additionally, inkjet head 76 discharges the metal ink from multiple nozzles through, for example, a piezoelectric method using a piezoelectric element.

Sintering section 74 includes infrared irradiation device 78 (refer to Fig. 2). Infrared irradiation device 78 is, for example, an infrared heater, and is a device that irradiates and heats the discharged metal ink with infrared light. Based on the control of control device 28 (see Fig. 2) of board manufacturing device 10, infrared irradiation device 78 can be switched to, for example, a state of being heated to a first temperature and a state of being heated to a second temperature higher than the first temperature. For example, when the metal ink is heated by infrared irradiation device 78 of the first temperature, the organic solvent is vaporized and dried. When the metal ink is heated by infrared irradiation device 78 at the second temperature of high temperature, the metal ink is sintered to form a final wire. The sintering of the metal ink referred to herein means a phenomenon in which by applying thermal energy, an organic solvent is vaporized or a protective film of the metal fine particles, that is, a dispersing agent, is decomposed, and the metal fine particles are brought into contact with each other or fused to increase the conductivity. Board manufacturing device 10 executes, for example, drying at the first temperature on the discharged metal ink, and then executes the sintering at the second temperature to form a wire. The wire forming method is not limited to the above method. Control device 28 may execute the sintering via one heating without executing the drying step.

Second shaping unit 24 is a unit for shaping a resin layer on base table 60 of stage 52, and includes second print section 84 and curing section 86. Second print section 84 includes inkjet head 88 (refer to Fig. 2). Inkjet head 88 discharges an ultraviolet curable resin. The ultraviolet curable resin is, for example, a resin that has an insulating property and that is cured by irradiation with an ultraviolet ray. A method by which inkjet head 88 discharges the ultraviolet curable resin may be, for example, a piezoelectric method using a piezoelectric element, or may be a thermal method in which a resin is heated to generate air bubbles and discharged from multiple nozzles.

Curing section 86 includes flattening device 90 (refer to Fig. 2) and irradiation device 92 (refer to Fig. 2). Flattening device 90 flattens an upper surface of the ultraviolet curable resin discharged by inkjet head 88, and makes the thickness of the ultraviolet curable resin uniform by, for example, evening out the surface of the ultraviolet curable resin while scraping off an excess resin with a roller or a blade. Additionally, irradiation device 92 includes a mercury lamp or an LED as a light source and irradiates the discharged ultraviolet curable resin with ultraviolet rays. Thus, the discharged ultraviolet curable resin is cured to form a resin layer having an insulating property.

Third shaping unit 25 is a unit for shaping a connection section connecting the electrode of the electronic component and the terminal portion of the wire on base table 60, and includes third print section 100 and first heating section 102. Third print section 100 includes dispenser 106 (see Fig. 2). Dispenser 106 discharges a conductive resin paste. The conductive resin paste is, for example, a resin that is cured by heating at a relatively low temperature, in which micrometer-sized metal particles (such as silver particles) are dispersed. The metal particle is, for example, flake-like. The viscosity of the conductive resin paste is, for example, higher than that of the metal ink.

First heating section 102 includes, for example, pair of heating plates 108 (see Fig. 2) facing each other in the Z-axis direction. Pair of heating plates 108 is a device that heats the conductive resin paste applied from dispenser 106. For example, the board which is a manufacturing target is heated by being sandwiched between pair of heating plates 108 after the conductive resin paste is discharged onto the terminal portions of the wire. **In** the conductive resin paste, the resin is cured by the heating and bonded to the terminal portion. Next, the electronic component is mounted on the board, and the electrode of the electronic component is arranged on the conductive resin paste bonded to the terminal portion. Then, in a state where the electrode of the electronic component is arranged on the terminal portion via the conductive resin paste, the board is heated while being sandwiched by pair of heating plates 108. **In** the conductive resin paste, the resin is cured by the heating to shrink, and the flaky metal particles dispersed in the resin come into contact with each other. As a result, the conductive resin paste exhibits conductivity. The electronic component is electrically connected to the terminal portion via the conductive resin paste. The resin of the conductive resin paste is an organic adhesive, exerts an adhesive force by being cured by heating, and physically bonds the terminal portion (wire) and the electrode.

The above-described method of heating the metal ink and the conductive resin paste is an example. For example, the conductive resin paste may be heated using an infrared heater. Alternatively, the metal ink may be sintered using heating plate 108. In addition, board manufacturing device 10 may include a heating unit other than infrared irradiation device 78 and heating plate 108, for example, an electric furnace that heats the manufacturing object in a furnace.

Mounting unit 27 includes supply section 120 and mounting section 122. Supply section 120 is a device that supplies electronic components to be mounted on a board, and includes, for example, tape feeder 124. Tape feeder 124 supplies the electronic component to a supply position from a carrier tape in which the electronic component is taped. The method of supplying the electronic component is not limited to the method using tape feeder 124, and may be, for example, a method using a tray-type supply device that supplies electronic components arranged on a tray. Supply section 120 can supply probe pins. The probe pin is formed of a metal such as copper or gold, and is used for, for example, an electrical connection between a wire of a certain layer and a wire of another layer. Alternatively, the probe pin is used for electrical connection between a certain board and another board. The method of supplying the probe pins is not particularly limited, but for example, the probe pins may be arranged on a tray and supplied.

Mounting section 122 includes mounting head 126 (refer to Fig. 2) and movement device 128 (refer to Fig. 2). Mounting head 126 includes a suction nozzle (not illustrated) for picking up and holding the electronic component. The suction nozzle picks up and holds the electronic component by suctioning air through the supply of a negative pressure from a positive and negative pressure supply device (not illustrated). The suction nozzle is separated from the electronic component by supplying a slight positive pressure from the positive and negative pressure supply device. In addition, movement device 128 moves mounting head 126 between the supply position of tape feeder 124 and the board placed on base table 60. Mounting section 122 drives movement device 128 to hold the electronic component supplied from tape feeder 124 on the suction nozzle of mounting head 126, and mounts the electronic component held by mounting head 126 on the board.

Fig. 2 is a block diagram of board manufacturing device 10. As illustrated in Fig. 2, control device 28 includes controller 130, multiple drive circuits 132, storage device 133, and external interface (IF) 135. Controller 130 includes a CPU, mainly includes a computer, and is connected to multiple drive circuits 132. Multiple drive circuits 132 is an amplifier of a motor or the like, and is connected to above-described electromagnetic motors 38 and 56, holding device 62, lifting and lowering device 64, inkjet head 76, infrared irradiation device 78, inkjet head 88, flattening device 90, irradiation device 92, dispenser 106, heating plate 108, tape feeder 124, mounting head 126, and movement device 128. Storage device 133 includes, for example, RAM, ROM, a flash memory, HDD, and the like. Storage device 133 stores control program 133A. Controller 130 executes control program 133A via the CPU, and controls the operations of conveyance device 20, first shaping unit 22, second shaping unit 24, third shaping unit 25, and mounting unit 27 via drive circuits 132. In the following description, control device 28 that executes control program 133A in controller 130 may be simply referred to as a device name. For example, "control device 28 controls X-axis slide mechanism 30" means that control device 28 executes control program 133A via the CPU of controller 130 and controls X-axis slide mechanism 30 via drive circuit 132.

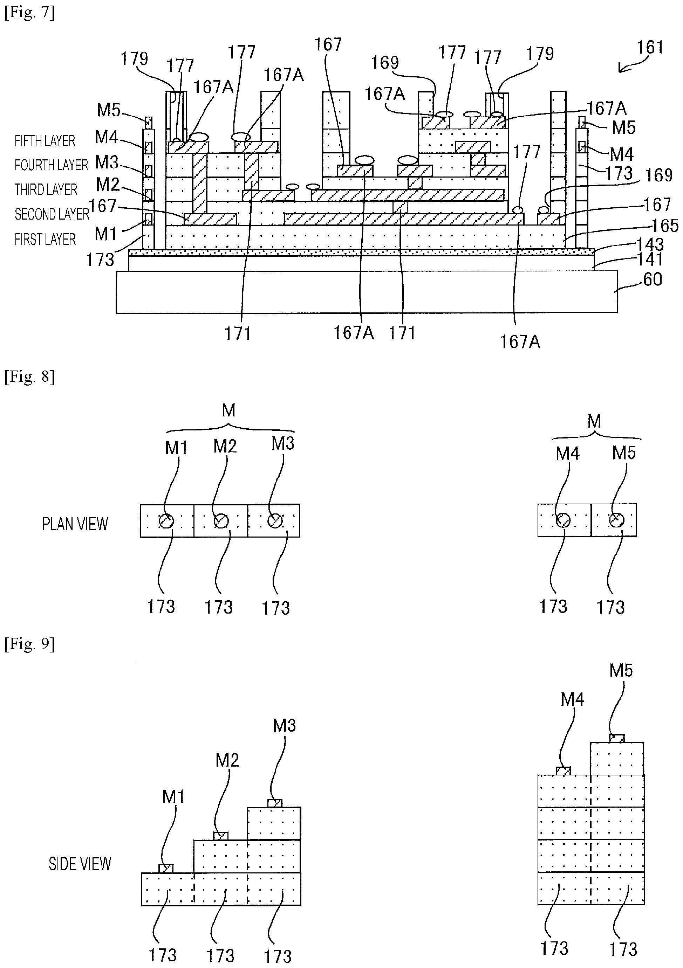

External IF 135 is, for example, a LANIF, and is connected to first management device 138 and second management device 139 via local network 137. First management device 138 is, for example, a device that generates and stores three-dimensional data of a manufacturing object (board or the like) to be additively manufactured by an inkjet method. Control device 28 stores three-dimensional data 133B acquired from first management device 138 in storage device 133, controls first shaping unit 22 and the like based on three-dimensional data 133B, and executes manufacturing of the board. Three-dimensional data 133B includes, for example, data obtained by slicing board 161 (see Fig. 9), which is a manufacturing object, for each layer. Three-dimensional data 133B includes data of each layer for manufacturing reference mark M and mark pedestal 173 (see Fig. 9) to be described later. The three-dimensional data of board 161, reference mark M, and mark pedestal 173 may be separate data.

Second management device 139 is a device that generates and stores job data (control data, a so-called recipe) used in a mounting process of mounting electronic components on a manufactured board. Control device 28 stores job data 133C acquired from second management device 139 in storage device 133, and determines the type of electronic component to be mounted and the mounting position based on job data 133C, and controls mounting unit 27. The configuration illustrated in Fig. 2 is an example. First management device 138 that generates three-dimensional data 133B and second management device 139 that generates job data 133C may be the same device. Board manufacturing device 10 may have a function of generating three-dimensional data 133B and job data 133C.

In board manufacturing device 10 of the present embodiment, multiple resin layers are built up layer by layer on base table 60 by the above-described configuration, and wires are appropriately formed in each resin layer. Further, board manufacturing device 10 connects the electrodes of the electronic components to the terminal portions of the wires through the conductive resin paste to manufacture the board on which the electronic components are mounted. In addition, board manufacturing device 10 executes correction using the reference mark in order to adjust the position where the conductive resin paste is discharged and to adjust the position where the electronic component is mounted. This reference mark is a so-called fiducial mark. Board manufacturing device 10 also shapes the fiducial mark by using an inkjet method.

Specifically, Fig. 3 is a plan view illustrating a region in pallet 141 arranged on base table 60. As illustrated in Fig. 3, pallet 141 is, for example, a metal plate member having a rectangular shape in plan view. In a state where pallet 141 is placed on base table 60, pallet 141 is arranged in a state in which the longitudinal direction thereof is along the X-axis direction. Both ends of pallet 141 in the X-axis direction are held by holding device 62. The shape, arrangement, number, and the like of the regions illustrated in Fig. 3 are merely examples.

Release film 143 is attached onto pallet 141. For example, control device 28 sets formation area 145 in release film 143, and manufactures a board in formation area 145. Formation area 145 is, for example, a square region in plan view, and is set at the center of pallet 141. First waste ejection area 147 is set on one side (upper side in Fig. 3) of formation area 145 in the X-axis direction. When ink (metal ink or the like) is discharged from inkjet heads 76 and 88 in the cleaning of the nozzle or the like, control device 28 executes ink discharge in first waste ejection area 147. In addition, second waste ejection area 148 is set on a side (lower side in Fig. 3) opposite to first waste ejection area 147 across formation area 145 in the X-axis direction. In the case of discharging ink (conductive resin paste) from dispenser 106 in cleaning of dispenser 106 or the like, control device 28 discharges the ink to second waste ejection area 148. Temperature sensor measurement area 149 is set on one side (right side in Fig. 3) of formation area 145 in the Y-axis direction. Temperature sensor measurement area 149 is a region for measuring the temperature of release film 143 in order to confirm whether the temperature of release film 143 has reached the peeling temperature. The temperature measurement of release film 143 may be executed by control device 28 using a temperature sensor or by a person by hand work.

Further, mark formation areas 150 and 151 are provided on both sides of formation area 145 in the X-axis direction. Mark formation area 150 is set, for example, between first waste ejection area 147 and formation area 145 in the X-axis direction. Mark formation area 151 is set, for example, outside formation area 145 in the X-axis direction and on both sides of second waste ejection area 148 in the Y-axis direction. Reference mark M is formed in each of pair of mark formation areas 150 and 151. Reference mark M will be described in detail later.

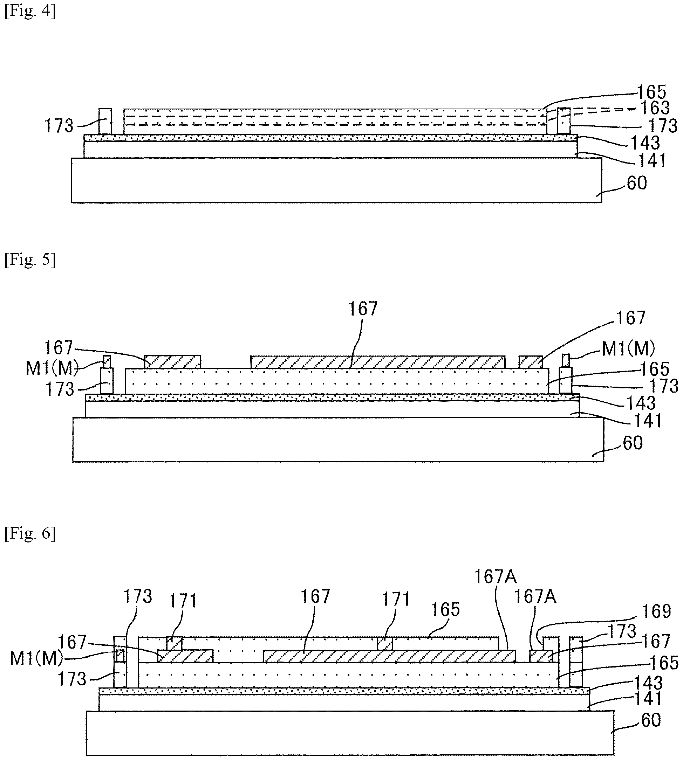

Next, an example of a board manufacturing step will be described. Figs. 4 to 6 illustrate a state in which the resin layer and the wire are shaped. In the following description, a case of manufacturing five-layer board 161 illustrated in Fig. 9 will be described as an example. First, control device 28 causes X-axis slide mechanism 30 and Y-axis slide mechanism 32 to move stage 52 below second shaping unit 24. Control device 28 causes second shaping unit 24 to discharge the ultraviolet curable resin in a thin film shape from inkjet head 88 of second print section 84 to the upper surface of release film 143 of stage 52. Control device 28 causes the ultraviolet curable resin to be discharged to a position based on three-dimensional data 133B of the manufacturing target. For example, control device 28 causes flattening device 90 of curing section 86 to flatten the ultraviolet curable resin discharged in a thin film shape so that the thin film becomes uniform. In addition, for example, control device 28 may further discharge the ultraviolet curable resin onto the flattened ultraviolet curable resin to be semi-cured, and may smooth the unevenness of the surface generated by the flattening by using the leveling effect of the semi-cured ultraviolet curable resin.

Control device 28 causes irradiation device 92 to irradiate and cure the ultraviolet curable resin that has been flattened or smoothed with ultraviolet rays. Thereby, as illustrated in Fig. 4, thin film resin layer 163 is formed on release film 143 (in formation area 145 illustrated in Fig. 3). For example, control device 28 further discharges the ultraviolet curable resin onto thin film resin layer 163, and repeatedly executes flattening, smoothing, and curing. Thus, as illustrated in Fig. 4, first-layer resin layer 165 is formed on release film 143 by building up thin film resin layer 163. It is to be noted that control device 28 may execute flattening or the like each time scanning of the ultraviolet curable resin is executed multiple times without executing flattening, smoothing, and curing each time the ultraviolet curable resin is discharged.

Next, control device 28 causes X-axis slide mechanism 30 and Y-axis slide mechanism 32 to move stage 52 below first shaping unit 22. Control device 28 causes first shaping unit 22 to discharge the metal ink from inkjet head 76 of first print section 72 onto the upper surface of resin layer 165. Control device 28 causes the metal ink to be discharged to a position based on the circuit pattern set in three-dimensional data 133B. Next, control device 28 causes sintering section 74 of first shaping unit 22 to irradiate the discharged metal ink with infrared light from infrared irradiation device 78. For example, after discharging the metal ink in one scan, control device 28 sets infrared irradiation device 78 to the first temperature and heats the discharged metal ink. As a result, a part of the organic solvent is vaporized and dried in the metal ink. When the discharge and the drying are executed repeatedly and building-up is executed by a desired thickness, control device 28 sets infrared irradiation device 78 to the second temperature higher than the first temperature, and executes sintering of the built-up metal ink. Thus, as illustrated in Fig. 5, wire 167 having the predetermined thickness and the wire pattern set in three-dimensional data 133B is formed on resin layer 165.

Next, control device 28 moves stage 52 below second shaping unit 24. Similarly to first-layer resin layer 165, control device 28 repeatedly executes discharging, flattening, smoothing, and curing of the ultraviolet curable resin, and forms second-layer resin layer 165 on first-layer resin layer 165. Second-layer resin layer 165 is formed to cover wire 167 on first-layer resin layer 165. Further, as illustrated in Fig. 6, control device 28 forms cavity 169 for exposing a part of first-layer wire 167 in second-layer resin layer 165. A part of wire 167 exposed in cavity 169 functions as terminal portion 167A on which electronic component 181 (see Fig. 9) is mounted. For example, control device 28 further discharges the metal ink onto first-layer wire 167, and forms interlayer wire (via) 171 that connects first-layer wire 167 to upper-layer wire 167 at any position in second-layer resin layer 165. The connection of wires 167 of different layers may be executed using probe pins 183 (see Fig. 9) without using interlayer wire 171.

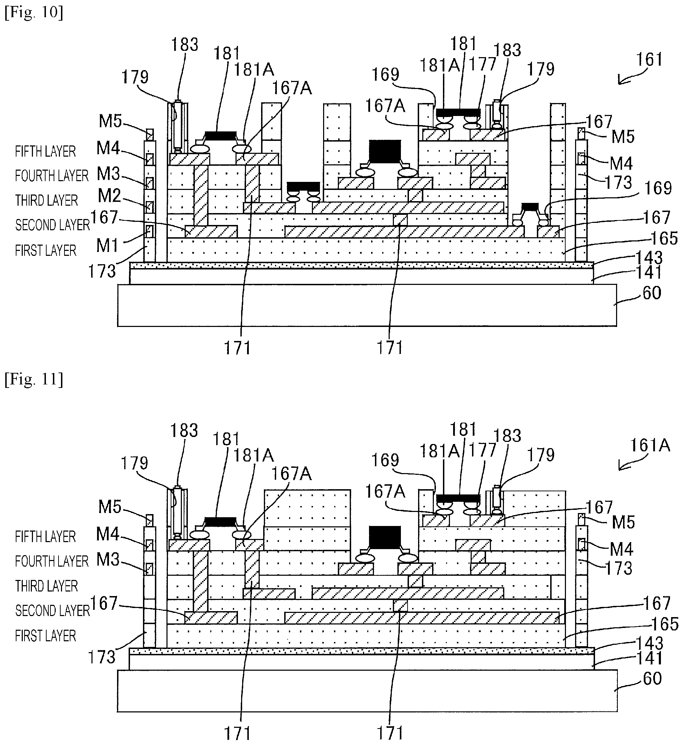

Control device 28 repeatedly executes the step of forming resin layer 165 and the step of forming wire 167 to manufacture five-layer board 161 illustrated in Fig. 7. **In** the following description, each layer of board 161 is referred to as a first layer, second layer, third layer, ..., and fifth layer in order from the bottom. As illustrated in Fig. 7, board 161 has resin layer 165 (hereinafter, may be referred to as a terminal-attached resin layer) provided with terminal portion 167A on a surface thereof. **In** the example illustrated in Fig. 7, all of the first to fifth layers are the terminal-attached resin layers. Cavity 169 on which electronic component 181 (see Fig. 10) is mounted is formed in the terminal-attached resin layer of each layer.

Here, board manufacturing device 10 can execute the steps up to the mounting of electronic component 181 in the same device. As electronic component 181 to be mounted, various types of electronic components 181 that can be supplied from supply section 120 can be used. Different types of electronic components 181 may have different connected circuit configurations, and the number of layers (mounting height) of the circuits also differs. That is, the number of layers of wire 167 and resin layer 165 to be built up and formed below the position where electronic component 181 is mounted differs. In other words, in the case where the terminal-attached resin layer provided with terminal portion 167A connected to electronic component 181 on the surface is multiple layers on board 161 that is shaped by being built up , the heights of the multiple terminal-attached resin layers are different from each other. The height of the terminal-attached resin layer varies for various reasons, including the type of electronic component 181, the size of electronic component 181, the number of electrodes of electronic component 181, the overall shape of the shaped object to be manufactured, or the like.

Meanwhile, in the three-dimensional additive manufacturing using the resin as in the present embodiment, for example, there is a possibility that the ultraviolet curable resin is shrunk by the curing treatment of the ultraviolet curable resin using ultraviolet rays. Further, there is a possibility that the ultraviolet curable resin shrinks due to heat generated in the process of curing the metal ink or the conductive resin paste. As a result, the positions of terminal portions 167A of the terminal-attached resin layers may be slightly displaced depending on the number of layers below. Then, in the manufacturing step of board 161, control device 28 additively manufactures mark pedestal 173 having the same height as the terminal-attached resin layer in parallel, and forms reference mark M on mark pedestal 173.

In the example illustrated in Fig. 7, terminal portion 167A is formed in each of the five layers. That is, electronic component 181 is mounted on all five terminal-attached insulating layers (see Fig. 10). In this case, control device 28 forms mark pedestal 173 having a height corresponding to each of the five layers, and forms reference mark M on each of the five types of mark pedestals 173. In the following description, when reference marks M corresponding to the respective layers of the first layer to fifth layer are distinguished from each other, the number of layers are added after the reference marks as reference marks M1, M2, M3, M4, and M5. When reference marks M1 to M5 are collectively referred to, reference marks M1 to M5 are referred to as reference mark M.

As illustrated in Fig. 4, for example, in the resin layer forming step of forming first-layer resin layer 165, control device 28 forms the first layer of mark pedestal 173 in each of mark formation areas 150 and 151. Control device 28 forms the first layer of mark pedestal 173 in parallel with resin layer 165 in the same procedure as the procedure of forming resin layer 165 of formation area 145. More specifically, each procedure of discharging, flattening, smoothing, and curing by ultraviolet rays of the ultraviolet curable resin when resin layer 165 is formed is performed in the same procedure, and a first layer of mark pedestal 173 is formed with an ultraviolet curable resin. For example, in a case where the ultraviolet curable resin is discharged by inkjet head 88 in order to shape thin film resin layer 163 of a certain layer, control device 28 discharges the ultraviolet curable resin to formation area 145 and also to mark formation areas 150 and 151. That is, thin film resin layer 163 having the same height as resin layer 165 and mark pedestal 173 is shaped in parallel. Further, for example, in the case of flattening the discharged ultraviolet curable resin, control device 28 also flattens the ultraviolet curable resin in formation area 145 via the rollers of flattening device 90, and also flattens the ultraviolet curable resin in mark formation areas 150 and 151. Control device 28 forms the first layer of mark pedestal 173 on reference marks M1 to M5. Control device 28 does not have to form resin layer 165 and mark pedestal 173 in parallel. For example, after forming one layer of resin layer 165 in formation area 145, control device 28 may form the first layer of mark pedestal 173 in mark formation areas 150 and 151.

As illustrated in Fig. 5, for example, in the wire forming step of forming wire 167 on first-layer resin layer 165, control device 28 forms reference mark M1 on mark pedestal 173 for reference mark M1. Control device 28 forms reference mark M1 in the same procedure as the procedure of forming wire 167 in formation area 145 and in parallel with wire 167. More specifically, the procedures of the discharging, the drying, and the sintering of the metal ink when forming wire 167 are performed in the same procedure in the shaping of reference mark M1, and reference mark M1 is formed with the metal ink. For example, when the metal ink is discharged by inkjet head 76 in order to shape wire 167, control device 28 causes the metal ink to be discharged to mark formation areas 150 and 151 while discharging the metal ink to formation area 145. Control device 28 does not shape reference mark M at this stage for mark pedestal 173 for other reference marks M2 to M5.

In the resin layer forming step of forming resin layer 165 of each layer, control device 28 executes the above-described step of forming mark pedestal 173. Mark pedestals 173 of reference marks M1 to M5 are built up in this order. In the wire forming step of forming wire 167 of each layer, control device 28 forms reference mark M corresponding to the height (in the same layer). For example, control device 28 forms reference mark M2 in the wire forming step of second-layer wire 167, and forms reference mark M3 in the wire forming step of third-layer wire 167. Therefore, in the case of manufacturing board 161 illustrated in Fig. 10, five types of mark pedestals 173 and reference marks M1 to M5 corresponding to the five layers from the first layer to fifth layer are formed.

Fig. 8 is a plan view when reference marks M of the five layers are formed, and illustrates reference marks M on the upper side (first waste ejection area 147 side) in Fig. 3. Fig. 9 illustrates a side view when reference mark M is formed, and illustrates reference mark M on the upper side (first waste ejection area 147 side) in Fig. 3. As illustrated in Figs. 3, 8, and 9, for example, control device 28 forms each of reference marks M1 to M5 along a direction parallel to the Y-axis direction in each of mark formation areas 150 and 151. In the example of Fig. 3, in mark formation area 150, control device 28 forms the first layer, second layer, and third layer of reference marks M1, M2, and M3 on a first side (left side in Fig. 3) in the Y-axis direction, and the fourth layer and fifth layer of reference marks M4 and M5 on a second side. Further, in mark formation area 151, control device 28 forms the fourth layer and fifth layer of reference marks M4 and M5 on the first side (left side in Fig. 3) in the Y-axis direction, and the first layer, second layer, and third layer of reference marks M1, M2, and M3 on the second side. Reference marks M of mark formation areas 150 and 151 have the same distance between pair of reference marks M of the respective layers. More specifically, as illustrated in Fig. 3, for example, distance 175 between pair of reference marks M1 formed in mark formation areas 150 and 151 is the same as distance 176 between pair of reference marks M2. Similarly, for other layers, the distance between pair of reference marks M corresponding to a certain layer is the same as the distance between pair of reference marks M corresponding to another layer.

Further, as illustrated in Figs. 8 and 9, respective mark pedestals 173 of reference marks M1 to M5 are increased by one layer in this order. In Fig. 9, a broken line is illustrated at the boundary portion for the sake of convenience so that respective mark pedestals 173 of reference marks M1 to M5 can be distinguished. That is, the mark pedestal in the present disclosure is, for example, a portion corresponding to a lower resin layer built up to form certain reference mark M.

Further, mark pedestals 173 of adjacent reference marks M1 to M3 are connected to each other, and mark pedestals 173 of the adjacent reference marks M4 and M5 are also connected to each other. Mark pedestals 173 of adjacent reference marks M may be separated from each other. Reference mark M has a circular shape in plan view illustrated in Fig. 8, for example. The thickness of reference mark M along the Z-axis direction is the same as the thickness of wire 167. The thickness of reference mark M may be different from the thickness of wire 167. For example, reference mark M may be thinner than wire 167. In this case, in the formation of reference mark M, the number of layers built up may be reduced compared to the step of forming wire 167.

Control device 28 uses reference mark M of each layer formed in parallel with the manufacture of board 161 to correct the position at which the conductive resin paste is discharged, the position at which electrode 181A of electronic component 181 is arranged, and the position at which probe pin 183 is arranged. Specifically, as illustrated in Fig. 7, for example, after forming five layers of board 161, control device 28 discharges conductive resin paste 177 to terminal portion 167A of each layer. Control device 28 moves stage 52 below third shaping unit 25. Control device 28 causes third print section 100 of third shaping unit 25 to discharge conductive resin paste 177 from dispenser 106 onto terminal portion 167A exposed in cavity 169. Further, control device 28 causes conductive resin paste 177 to be discharged from dispenser 106 onto terminal portion 167A of wire 167 exposed in insertion hole 179 into which probe pin 183 (see Fig. 10) is inserted.

Control device 28 executes correction using reference mark M in adjustment of the position where conductive resin paste 177 is discharged. Specifically, control device 28 executes the discharging of conductive resin paste 177 in the order of, for example, the first layer, the second layer, ..., and the fifth layer. When discharging conductive resin paste 177 to terminal portion 167A provided on first-layer resin layer 165, control device 28 executes correction using reference mark M1 of each of mark formation areas 150 and 151. A known method can be adopted as the correction processing. For example, control device 28 detects the center position (center of a circle) of reference mark M1 of mark formation area 150 and the center position of reference mark M1 of mark formation area 151. Control device 28 detects the position of terminal portion 167A for discharging conductive resin paste 177. As a method of detecting the center position and the position of terminal portion 167A, for example, a method of making detection based on image data obtained by imaging reference mark M1 and terminal portion 167A with a camera attached into board manufacturing device 10 can be adopted. The attaching position of the camera is not particularly limited, but may be, for example, attached to dispenser 106 or mounting head 126. For example, the discharge position of conductive resin paste 177 of each layer is set in three-dimensional data 133B. Control device 28 detects an error between the position (the actual position) of terminal portion 167A and the discharge position (the position of the setting data) based on the center position of two reference marks M1 and the position of terminal portion 167A, and corrects the discharge position.

As described above, up to the resin layer forming step of forming resin layer 165 of a certain terminal-attached resin layer, control device 28 forms mark pedestal 173 in the same procedure as the procedure of forming resin layer 165 of formation area 145 and in parallel with resin layer 165 of formation area 145, and forms mark pedestal 173 having the same height as the terminal-attached resin layer. In the wire forming step of forming wire 167 of the terminal-attached resin layer, control device 28 forms reference mark M in the same procedure as the procedure of forming wire 167 and in parallel with wire 167. Accordingly, correction using reference mark M and mark pedestal 173 formed in the same procedure as the target member (terminal portion 167A and resin layer 165 below terminal portion 167A) for position adjustment can be executed. In other words, by shaping in the same manner, the same change (shrinkage of resin or the like) as resin layer 165 and wire 167 can be reproduced on reference mark M and mark pedestal 173. Therefore, the correction of the discharge position of conductive resin paste 177 and the correction of the arrangement position of electronic component 181 described later can be executed with high accuracy using reference mark M.

Control device 28 executes the same correction as that for the first layer in discharging conductive resin paste 177 in resin layer 165 positioned above the second layer. Specifically, when adjusting the position where conductive resin paste 177 is discharged to second-layer terminal portion 167A, control device 28 executes correction using pair of reference marks M2. Further, for example, when adjusting the position where conductive resin paste 177 is discharged to terminal portion 167A of fifth-layer, control device 28 executes correction using pair of reference marks M5. Control device 28 need not discharge conductive resin paste 177 in order for each layer. For example, in a plan view of board 161, control device 28 may discharge conductive resin paste 177 in order from terminal portion 167A closer to any corner in the X-axis direction and the Y-axis direction.

In accordance with the adjustment of the position where conductive resin paste 177 is discharged, control device 28 executes correction using reference mark M on mark pedestal 173 having the same height as the terminal-attached resin layer on which electronic component 181 to be bonded by conductive resin paste 177 to be discharged is mounted. According to this, even when the error due to shrinkage or the like of the resin is different in each layer, conductive resin paste 177 can be accurately discharged to terminal portion 167A of each layer.

When the discharge of conductive resin paste 177 is completed, control device 28 heats conductive resin paste 177 via first heating section 102. For example, control device 28 arranges pallet 141 on which board 161 is placed between pair of heating plates 108 facing each other in the Z-axis direction, and heats conductive resin paste 177 via heating plate 108. Accordingly, conductive resin paste 177 is bonded to terminal portion 167A in cavity 169 and terminal portion 167A in insertion hole 179. The work of arranging pallet 141 between pair of heating plates 108 may be executed by a machine using, for example, a robot or a conveyor device, or may be performed by a person by hand work.

Next, control device 28 moves stage 52 on which board 161 is placed to mounting unit 27. Control device 28 causes mounting unit 27 to mount electronic component 181. Control device 28 supplies any electronic component 181 from tape feeder 124 to the supply position, and arranges electronic component 181 on conductive resin paste 177 of board 161 via the suction nozzle of mounting head 126. Control device 28 causes movement device 128 of mounting section 122 to arrange electronic component 181 held by mounting head 126 in cavity 169. At this time, control device 28 arranges electronic component 181 such that electrode 181A of electronic component 181 is in contact with conductive resin paste 177 discharged onto terminal portion 167A. Electrode 181A of electronic component 181 is a lead or a ball.

Control device 28 also executes correction using reference mark M even in the adjustment of the position where above-described electronic component 181 is arranged. Control device 28 controls mounting unit 27 based on job data 133C. For example, in job data 133C, the XYZ coordinates of the position at which electronic component 181 is mounted are set, and the XYZ coordinates are set by grouping electronic components 181 into each layer. When mounting electronic component 181 having one layer, control device 28 executes mounting using data of the group of one layer. Similarly to the above-described discharge position of conductive resin paste 177, control device 28 corrects the error between the position (actual position) of conductive resin paste 177 and the position (coordinates of the setting data) set in job data 133C, for example, based on the center position of reference mark M and the position of conductive resin paste 177 (terminal portion 167A) on which electronic component 181 is mounted. When the correction and mounting are completed for all electronic components 181 mounted on the first layer, control device 28 starts mounting the second layer. Control device 28 uses reference mark M1 for the position correction of electronic component 181 to be mounted on the first layer, and uses reference mark M2 for the position correction of electronic component 181 to be mounted on the second layer. Control device 28 executes the processing in the order of the first layer, the second layer, ..., and the fifth layer, and executes the correction using reference mark M on mark pedestal 173 having the same height in the mounting of each layer.

In accordance with the mounting step of mounting electronic component 181 on terminal portion 167A, control device 28 corrects the position where electronic component 181 is mounted on terminal portion 167A by using reference mark M provided on mark pedestal 173 having the same height as the terminal-attached resin layer on which electronic component 181 is mounted. According to this, even when an error due to shrinkage or the like of the resin is different for each layer, electronic component 181 can be accurately mounted by using mark pedestal 173 and reference mark M corresponding to each layer.

In addition, after the mounting of all electronic components 181 is completed for a certain layer, for example, for mounting of the first layer to the fifth layer, control device 28 starts mounting of electronic component 181 of the next layer. Accordingly, control device 28 selects a terminal-attached resin layer on which electronic component 181 is to be mounted out of the multiple terminal-attached resin layers, executes correction using reference mark M, mounts all of electronic components 181 to be mounted on the selected terminal-attached resin layer, and then executes mounting to another terminal-attached resin layer. Accordingly, electronic components 181 to be corrected using same reference mark M1 can be collectively mounted. Since correction using different reference mark M is not required each time electronic component 181 is mounted, electronic component 181 can be mounted efficiently.

When the mounting of electronic component 181 is completed for all of the five layers, control device 28 executes mounting of probe pin 183. Control device 28 causes mounting unit 27 to insert probe pin 183 held by the suction nozzle of mounting section 122 into insertion hole 179. At this time, control device 28 arranges probe pin 183 such that the lower end of probe pin 183 comes into contact with conductive resin paste 177 discharged onto terminal portion 167A. Control device 28 also executes correction using reference mark M even in the adjustment of the position where probe pin 183 is arranged. As in the case of electronic component 181, for example, when probe pin 183 is mounted on the fifth layer, control device 28 corrects the position at which probe pin 183 is arranged using reference mark M5, and arranges probe pin 183. Thus, probe pins 183 can be accurately arranged in conductive resin paste 177. Control device 28 may mount probe pin 183 before electronic component 181 is mounted.

As illustrated in Fig. 10, when the arrangement of electronic component 181 and probe pin 183 is completed, control device 28 moves stage 52 to first heating section 102 to heat conductive resin paste 177. For example, in a state in which electronic component 181 and probe pin 183 are arranged on terminal portion 167A via conductive resin paste 177, control device 28 heats board 161 while sandwiching board 161 from both sides in the Z-axis direction via pair of heating plates 108. In conductive resin paste 177, the resin is cured, and electrode 181A of electronic component 181 and terminal portion 167A, or probe pin 183 and terminal portion 167A are electrically connected. Thus, a desired shaped object can be manufactured. The peeling temperature of release film 143 is set to, for example, the final heating temperature of above-described conductive resin paste 177. Therefore, when the heating of conductive resin paste 177 is completed, release film 143 is partially or entirely peeled from pallet 141 or board 161. Accordingly, the user can easily take out completed board 161 from stage 52.

In the embodiment, board manufacturing device 10 is an example of a manufacturing device. Inkjet heads 76 and 88 and dispenser 106 are examples of a discharging device. The ultraviolet curable resin is an example of a curable resin. The metal ink is an example of a first metallic fluid. Conductive resin paste 177 is an example of a second metallic fluid. The steps of Figs. 4 and 6 are examples of a resin layer forming step and a resin layer forming process. The step of Fig. 5 is an example of a wire forming step and a wire forming process. Fig. 9 is an example of a mounting step.

Hereinbefore, according to the embodiment, the following effects are achieved.

Control device 28 of one aspect of the present embodiment forms mark pedestal 173 by building up resin layer 165 in mark formation areas 150 and 151 up to the resin layer forming step of forming resin layer 165 of the terminal-attached resin layer. In the wire forming step of forming wire 167 of the terminal-attached resin layer, control device 28 forms reference mark M on mark pedestal 173. Then, control device 28 forms mark pedestals 173 corresponding to the heights of the multiple terminal-attached resin layers in mark formation areas 150 and 151, respectively, and forms reference marks M1 to M5 on multiple mark pedestals 173. As a result, it is possible to form mark pedestal 173 in which resin layer 165 is built up to the same height as the terminal-attached resin layer, and to provide reference mark M thereon. The shrinkage or the like of the resin generated in the terminal-attached insulating layer or lower resin layer 165 can be generated (recreated) similarly to mark pedestal 173. Therefore, by using reference mark M on mark pedestal 173 formed in the same manner as the terminal-attached resin layer, it is possible to execute the correction in consideration of the shrinkage of the resin or the like, and to execute the position correction with high accuracy.

The present disclosure is not limited to the above-described embodiment, but can be performed in various forms in which various changes and improvements are made based on the knowledge of those skilled in the art.

For example, in the above embodiment, electronic component 181 is mounted on all the layers of five-layer board 161. That is, in the above embodiment, all the layers are the terminal-attached insulating layers; however, the configuration is not limited to this. For example, as in board 161A illustrated in Fig. 11, electronic components 181 may be mounted only in the third layer, the fourth layer, and the fifth layer. In the case of board 161A, the third layer, the fourth layer, and the fifth layer are terminal-attached resin layers. Control device 28 forms only reference marks M3, M4, and M5 corresponding to the third layer to fifth layer, and executes correction using reference marks M3 to M5. Note that control device 28 may form all of reference marks M1 to M5 in the manufacture of board 161A of the terminal-attached resin layer in the third layer to fifth layer.

Board 161 is not limited to five layers, and may be two or more layers.

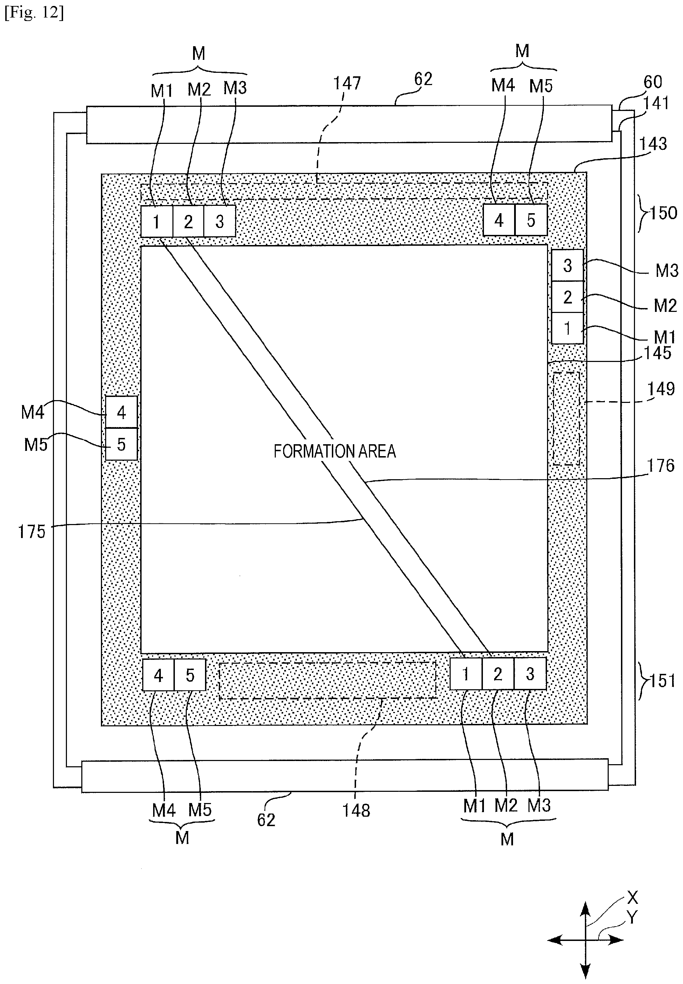

The arrangement of reference marks M illustrated in Fig. 3 is an example. For example, as illustrated in Fig. 12, three reference marks M may be provided for one layer. Then, control device 28 may execute correction using three reference marks M when adjusting the position at which conductive resin paste 177 is discharged in each layer, the position at which electronic component 181 is arranged, and the position at which probe pin 183 is arranged. Only one reference mark M may be provided for one layer, or four or more reference marks M may be provided for one layer. Accordingly, the number of mark formation areas may be one or three or more.

The formation procedures of mark pedestal 173 and resin layer 165 need not be the same. For example, in the formation of mark pedestal 173, flattening and smoothing may be omitted.

The procedure of forming reference mark M and wire 167 need not be the same. For example, the thickness of reference mark M may be thinner or thicker than wire 167.

Although board manufacturing device 10 includes mounting unit 27 and is configured to execute the process until mounting electronic component 181, mounting unit 27 need not be included. In this case, board manufacturing device 10 may execute manufacturing up to manufacturing of board 161 (board 161 in the state of Fig. 7 or the like) before electronic component 181 is mounted. Further, the mounting of electronic component 181 may be executed by another device.

Control device 28 may use reference mark M to correct the position of at least one of the discharge position of conductive resin paste 177, the arrangement position of electronic component 181, and the arrangement position of probe pin 183.

For electronic component 181 of each layer, control device 28 sequentially executes mounting of electronic component 181 from the lower layer as, after the mounting of all electronic components 181 of the first layer is completed, control device 28 mounts electronic components 181 of the second layer and then mounts electronic components 181 of the third layer.; however, the configuration is not limited to this. For example, control device 28 may mount electronic component 181 in order of the fifth layer, the fourth layer, ..., and the first layer, and may execute the mounting in any order such as the second layer, the fourth layer, the third layer, the fifth layer, and the first layer. Control device 28 does not necessarily need to collectively mount electronic components 181 of each layer. Control device 28 may mount first electronic component 181 of the first layer, then mount first electronic component 181 of the second layer, and then mount second electronic component 181 of the first layer again. For example, control device 28 may mount electronic components 181 in order from electronic component 181 closer to any corner in the X-axis direction and the Y-axis direction in a plan view of board 161.

In addition, the curable resin of the present disclosure is not limited to the ultraviolet curable resin, and various resins that are cured by light, heat, or the like can be used.

It should be noted that the content of the present disclosure is not limited to the dependent relationships described in the claims. For example, the present description also discloses a technical idea in which "the manufacturing method according to Claim 3" is changed to "the manufacturing method according to Claim 3 or 4" in Claim 5.

### Reference Signs List

10: board manufacturing device (manufacturing device), 28: control device, 52: stage, 76, 88: inkjet head (discharging device), 106: dispenser (discharging device), 145: formation area, 150, 151: mark formation area, 165: resin layer, 167: wire, 167A: terminal portion, 173: mark pedestal, 177: conductive resin paste (second metallic fluid), 181: electronic component, 181A: electrode, M, M1 to M5: reference mark.

## Claims

1. A manufacturing method comprising:
a resin layer forming step of forming a resin layer by discharging a curable resin to a formation area in a stage; and
a wire forming step of forming a wire by discharging a first metallic fluid containing metal fine particles on the resin layer,
wherein
the resin layer forming step and the wire forming step are repeatedly executed to form multiple terminal-attached resin layers each including a terminal portion on a surface of the resin layer, the terminal portion being a part of the wire and connected to an electronic component to be mounted on the wire,
a mark pedestal is formed by building up the resin layer in a mark formation area up to a resin layer forming step of forming a resin layer of the terminal-attached resin layer out of multiple resin layer forming steps, the mark formation area being an area different from the formation area in the stage,
a reference mark is formed by discharging the first metallic fluid onto the mark pedestal in the wire forming step of forming the wire of the terminal-attached resin layer, and
when the multiple terminal-attached resin layers are formed at positions of different heights, the mark pedestals corresponding to the heights of the multiple terminal-attached resin layers are formed in the mark formation area, and the reference marks are formed on multiple mark pedestals, respectively.

2. The manufacturing method according to Claim 1, wherein
up to the end of the resin layer forming step of forming the resin layer of the terminal-attached resin layer, the mark pedestal is formed in the same procedure as a procedure of forming the resin layer of the formation area and in parallel with forming the resin layer of the formation area, and the mark pedestal is formed at the same height as the terminal-attached resin layer, and
in the wire forming step of forming the wire of the terminal-attached resin layer, the reference mark is formed in the same procedure as a procedure of forming the wire and in parallel with forming the wire.

3. The manufacturing method according to Claim 1 or 2, further comprising:
a mounting step of mounting the electronic component on the terminal portion of the terminal-attached resin layer,
wherein, in the mounting step, correction of a position at which the electronic component is mounted on the terminal portion is executed using the reference mark provided on the mark pedestal having the same height as the terminal-attached resin layer on which the electronic component is to be mounted.

4. The manufacturing method according to Claim 3, wherein
in the mounting step, a second metallic fluid that connects an electrode of the electronic component and the terminal portion is discharged to the terminal portion, and in adjustment of a position at which the second metallic fluid is discharged, correction using the reference mark provided on the mark pedestal having the same height as the terminal-attached resin layer on which the electronic component is to be mounted is executed.

5. The manufacturing method according to Claim 3, wherein
when the mounting step is executed for each of the multiple terminal-attached resin layers, the terminal-attached resin layer on which the mounting step is executed is selected out of the multiple terminal-attached resin layers, correction using the reference mark is executed, all of the electronic components to be mounted on the selected terminal-attached resin layer are mounted, and then the mounting step of other terminal-attached resin layers is executed.

6. A manufacturing device comprising:
a stage;
a discharging device; and
a control device,
wherein
the control device
includes:
a resin layer forming process of forming a resin layer by discharging a curable resin to a formation area in the stage using the discharging device; and
a wire forming process of forming a wire by discharging a first metallic fluid containing metal fine particles on the resin layer using the discharging device,
executes the resin layer forming process and the wire forming process repeatedly to form multiple terminal-attached resin layers each including a terminal portion on a surface of the resin layer, the terminal portion being a part of the wire and connected to an electronic component to be mounted on the wire,
forms a mark pedestal by building up the resin layer in a mark formation area up to a resin layer forming process of forming a resin layer of the terminal-attached resin layer out of multiple resin layer forming processes, the mark formation area being an area different from the formation area in the stage,
forms a reference mark by discharging the first metallic fluid onto the mark pedestal using the discharging device in the wire forming process of forming the wire of the terminal-attached resin layer, and
when the multiple terminal-attached resin layers are formed at positions of different heights, forms the mark pedestals corresponding to the heights of the multiple terminal-attached resin layers in the mark formation area, and forms the reference marks on multiple mark pedestals, respectively.
